# EUROPÄISCHE PATENTSCHRIFT

(11) **EP 1 065 514 B1**
(45) Veröffentlichungstag und Bekanntmachung des Hinweises auf die Patenterteilung: **21.11.2001**
(21) Anmeldenummer: 00107466.5
(22) Anmeldetag: 06.04.2000
(51) Int. Cl.: G01R 33/46

(54) **Verfahren zur Bestimmung vom Silikongehalten**
Method to determine silicone content
Procédé de détermination de la teneur en silicone

(30) Priorität: 01.07.1999 DE 19930141
(43) Veröffentlichungstag der Anmeldung: 03.01.2001
(73) Patentinhaber: Degussa AG, 40474 Düsseldorf (DE)
(72) Erfinder: Michael, Günther, Dr., 63791 Karlstein (DE); Müller, Arndt, Dr., 63303 Dreieich (DE)

(56) Entgegenhaltungen:
- PATENT ABSTRACTS OF JAPAN vol. 99, no. 10, 29. Januar 1999 (1999-01-29) & JP 10 282027 A (SHIN ETSU CHEM CO LTD), 23. Oktober 1998 (1998-10-23)
- PATENT ABSTRACTS OF JAPAN vol. 96, no. 11, 8. Januar 1993 (1993-01-08) & JP 05 001150 A (SHIN ETSU CHEM CO LTD)

## Beschreibung

Verfahren zur quantitativen Bestimmung von Siliconoel bzw. Siloxanen im Spurenbereich in Kieselsäuren oder pyrogenen Oxiden durch quantitative Auswertung von 1H-NMR-Spektren
indem die Kieselsäure oder ein pyrogenes Oxid in einem organischen Lösungsmittel dispergiert wird, anschließend nach Abtrennen des Feststoffes die klare Phase zur Trockene gebracht wird und der Rückstand nach Aufnehmen in einem deuterierten Lösungsmittel 1H-NMR-spektroskopisch über das Integral der Methyl-Silylprotonen quantitativ im Hinblick auf das Siliconöl bzw. Siloxan ausgewertet wird.

### Beispiel

### Bestimmung von Siliconöl in Aerosil R 805 durch 1H-NMR-spektroskopische Auswertung

8 Gramm Aerosil R 805 werden in 140 g n-Hexan mit einem Dissolver 10 Minuten dispergiert (Durchmesser der Dispergierscheibe 40 mm, 2500 Umdrehungen pro Minute)
Zentrifugieren der Dispersion für 7 Minuten mit einer Hochleistungszentrifuge bei 14 000 Umdrehungen pro Minute
Dekantieren der klaren Phase in einen 250 ml Rundkolben und gravimetrische Bestimmung dieses abdekantierten Anteils und Berechnung des prozentualen Anteils bezogen auf die eingesetzten 140 g Hexan
Eindampfen der klaren Phase bis zur Trockene am Rotationsverdampfer bei 30°C
Aufnehmen und Übertragen des Rückstandes mit 2 Portionen von CDC13 in ein 1H-NMR-Glasröhrchen; wenn notwendig Zugabe von weiteren kleinen Mengen an CDC13 in das NMR-Röhrchens bis zu einer Füllhöhe von 8 cm
Aufnahme eines 1H-NMR-Spektrums mit einem 500 MHz-Gerät und Bestimmung des Integralanteils der Siliconölsignale im Bereich von 0 ppm indem das CHC13-Signal als innerer Standard auf 100 normiert wird. Korrektur des Methyl-Silylsignalintegrals entsprechend dem oben bestimmten Faktor.
Ablesen der quantitativen Siliconöl-Konzentration mit Hilfe einer Eichgeraden, die an Aerosil R 805 Proben mit bekanntem dotierten Gehalt an Siliconöl ermittelt wurde.

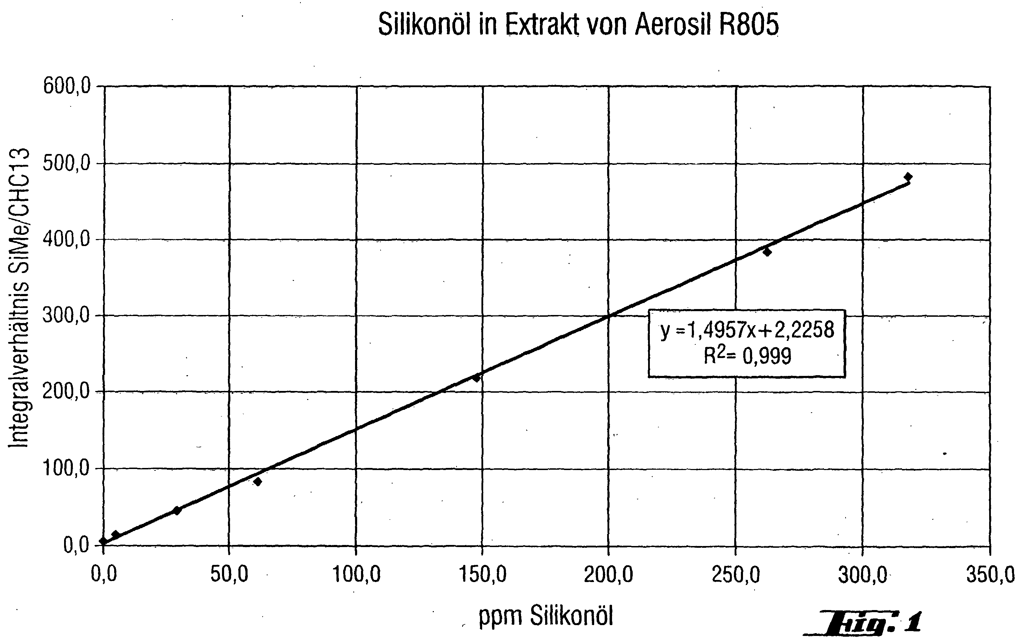

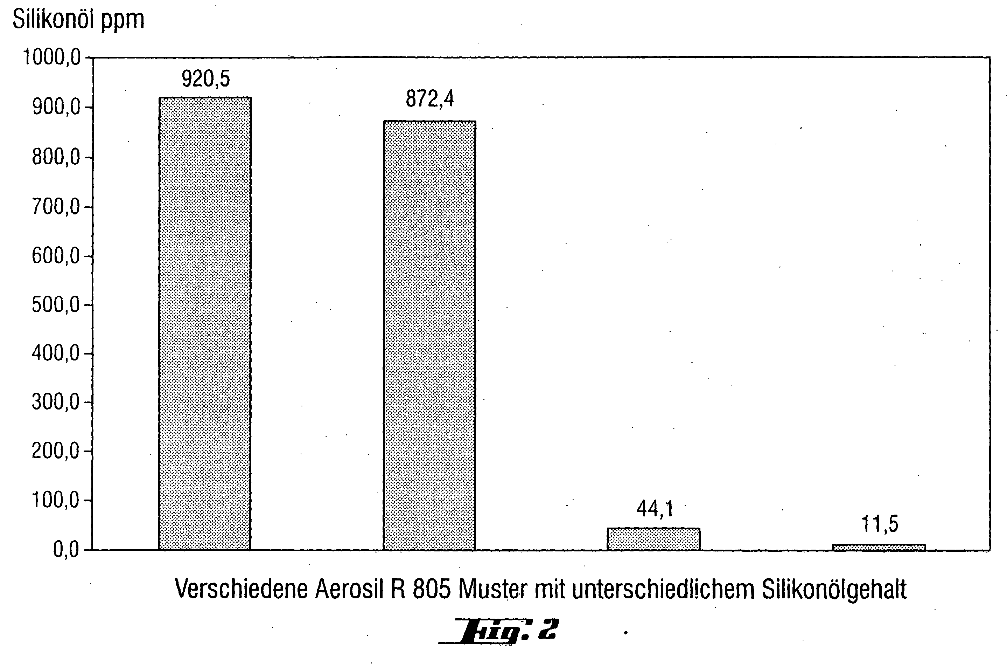

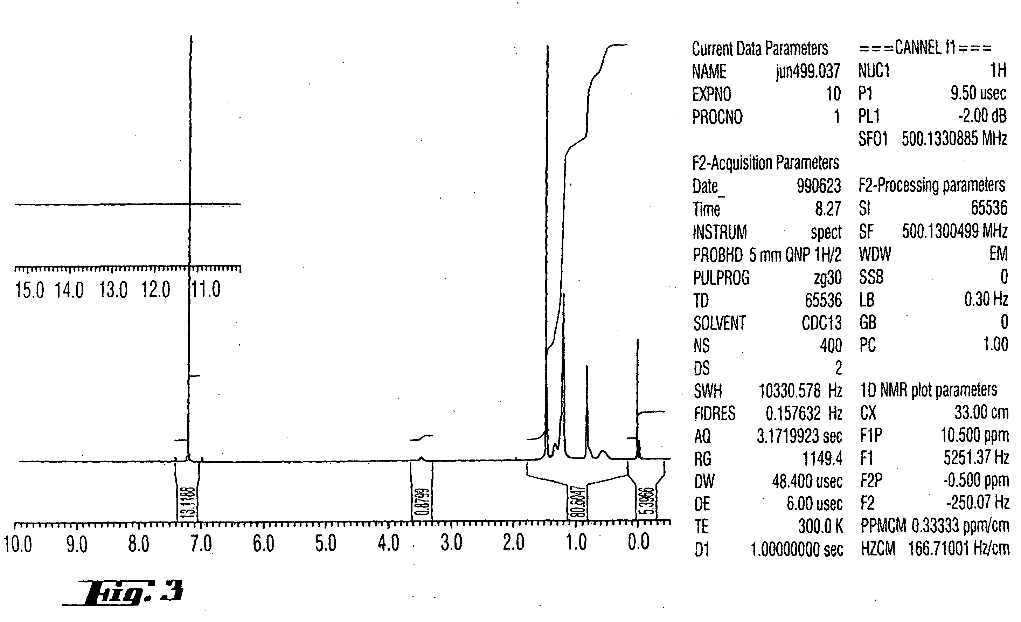

Die Ergebnisse sind in den Figuren 1 bis 3 dargestellt.

## Patentansprüche

1. Verfahren zur quantitativen Bestimmung von Siliconoel bzw. Siloxanen im Spurenbereich in Kieselsäuren oder pyrogenen Oxiden durch quantitative Auswertung von 1H-NMR-Spektren
indem die Kieselsäure oder ein pyrogenes Oxid in einem organischen Lösungsmittel dispergiert wird, anschließend nach Abtrennen des Feststoffes die klare Phase zur Trockene gebracht wird und der Rückstand nach Aufnehmen in einem deuterierten Lösungsmittel 1H-NMR-spektroskopisch über das Integral der Methyl-Silylprotonen quantitativ im Hinblick auf das Siliconöl bzw. Siloxan ausgewertet wird.

## Claims

1. A method for the quantitative determination of silicone oil or siloxanes in trace quantities in silicas or pyrogenic oxides by the quantitative evaluation of ¹H-NMR spectra
by dispersing the silica or a pyrogenic oxide in an organic solvent and then, after isolating the solids, evaporating the clear phase to dryness and, after taking up the residue in a deuterated solvent, quantitatively evaluating the silicone oil or siloxane via the integral of the methyl silyl protons indicated on the ¹H-NMR spectrum.

## Revendications

1. Procédé de détermination quantitative d'huile de silicone ou de siloxanes dans le domaine des traces dans des acides siliciques ou des oxydes pyrogéniques, par évaluation quantitative des spectres de RMN [¹H],
selon lequel l'acide silicique ou un oxyde pyrogénique est mis en dispersion dans un solvant organique, ensuite la phase claire est amenée à siccité après séparation du solide, et le résidu est évalué, après reprise dans un solvant deutéré, par spectroscopie RMN [¹H] par l'intermédiaire de l'intégrale des protons méthyle du silyle, quantitativement en huile de silicone ou en siloxane.
